# EUROPÄISCHE PATENTSCHRIFT

(11) **EP 0 423 291 B1**
(45) Veröffentlichungstag und Bekanntmachung des Hinweises auf die Patenterteilung: **18.11.1993**
(21) Anmeldenummer: 90906853.8
(22) Anmeldetag: 03.05.1990
(51) Int. Cl.: G01R 31/00, G05B 9/00, G05G 1/28

(54) **BEFEHLSGERÄT MIT ÜBERWACHTEM STELLTEIL**
CONTROL SWITCH WITH MONITORED OPERATING ELEMENT
DISPOSITIF DE TRANSMISSION D'ORDRE AVEC ORGANE DE COMMANDE CONTROLE

(30) Priorität: 04.05.1989 DE 3914704
(43) Veröffentlichungstag der Anmeldung: 24.04.1991
(73) Patentinhaber: BOTH, Helmut, D-55278 Ludwigshöhe (DE)
(72) Erfinder: BOTH, Helmut, D-55278 Ludwigshöhe (DE)
(74) Vertreter: Quermann, Helmut, Dipl.-Ing.
(86) Internationale Anmeldenummer: DE9000317
(87) Internationale Veröffentlichungsnummer: WO9013822

(56) Entgegenhaltungen:
- FR-A- 2 483 680
- FR-A- 2 519 565
- Patent Abstracts of Japan, vol. 7, No. 234 (P-230)(1379) 18 October 1983, & JP-A-58 123422

## Beschreibung

Die Erfindung betrifft ein Befehlsgerät mit einem beweglichen Stellteil zur Ein- und Fortleitung eines Eingangsbefehles an Steuersysteme, insbesondere von Maschinen, Anlagen oder dgl.

Die meisten, auf dem Markt befindlichen Befehlsgeräte wandeln die in ihr Stellteil, zum Beispiel Drucktaster, Schaltleiste, Schaltplatte usw., eingeleiteten Eingangsbefehle in andere physikalische Größen, wie elektrische Signale, Drücke, Strömungen und dgl. um, die dann in dieser Form an Steuersysteme, insbesondere von Maschinen oder Anlagen weitergeleitet werden.

Wird das mechanisch bewegbare Stellteil bzw. werden mit diesem eine funktionelle Einheit bildende, bewegbare Teile (die nachfolgend gleichfalls als Steilteil bezeichnet sind), wie innere Stößel, Hebel usw. solcher Befehlsgeräte unbemerkt blockiert oder verlieren sie durch Verklemmen, Korrosion in den Lagern, Unterkeilen oder andere Einflüsse eine ausreichende Beweglichkeit, so wird ein eingeleiteter Eingangsbefehl nicht angenommen und demzufolge auch nicht fortgeleitet und verarbeitet. Besonders gefährlich ist dies, wenn es sich dabei um Befehle zum Stillsetzen oder zur Verhinderung eines Ingangsetzens von Maschinen und Anlagen handelt.

Aus der FR-A-2 483 680 ist ein Geber mit Konventioneller Technik bekannt.

Aufgabe der Erfindung ist es, ein Befehlsgerät mit Stellteil zu gestalten, bei dem die Beweglichkeit des mechanisch beweglichen Stellteils dauernd selbsttätig überwacht wird und bei Verlust einer ausreichenden Beweglichkeit das gleiche Ausgangssignal erzeugt wird, das auch bei ungestörtem Betrieb durch die Einleitung eines Eingangsbefehles erzeugt worden wäre.

Gelöst wird die Aufgabe dadurch, daß das Stellteil durch einen Antrieb in eine oszillierende Bewegung versetzbar ist, diese durch das Stellteil zu einem Sensor fortleitbar und von diesem erkennbar ist, wobei die Einleitung eines Eingangsbefehles die oszillierende Bewegung dämpft. Erfindungsgemäß wird das durch den Eingangsbefehls mechanisch zu bewegende Stellteil durch einen geeigneten Antrieb so lange in eine dauernde oszillierende Bewegung bestimmter Amplitude versetzt, wie kein Eingangsbefehls eingeleitet wird und eine ausreichende Beweglichkeit vorhanden ist. Als Antrieb kann dabei beispielsweise ein magnetisches System dienen, das insbesondere aus einem Elektromagneten und einem, mit dem beweglichen Stellteil verbundenen Anker besteht. Desgleichen sind pneumatische, hydraulische, kapazitive oder piezoelektrische Antriebsformen denkbar. Die Richtung der Bewegung, bedingt durch den Eingangsbefehls relativ zur oszillierenden Bewegung kann dabei beliebig sein.

Die oszillierende Bewegung des mechanisch beweglichen Stellteiles wird zweckmäßig durch einen geeigneten Sensor, zum Beispiel ein elektromechanisch, pneumatisch, hydraulisch, kapazitiv, piezoelektrisch oder anderswirkendes System erkannt und als Sensorsignal abgegeben, das beispielsweise nach Diskriminierung in einem Amplituden-Diskriminator als binäres Ausgangssignal an das nachgeschaltete Steuersystem der Maschine oder Anlage abgebbar ist.

Die Speisung des Antriebes kann fremderregt durch einen eigenen Oszillator oder selbsterregt durch Rückführung des Sensorsignals in den Antrieb erfolgen.

Wird in das Stellteil ein Eingangsbefehl eingeleitet, erfährt es selbst (und alle oszillierenden Bestandteile desselben) zum Beispiel durch Anlegen an eine Reibfläche oder einen festen Anschlag eine Einschränkung der Beweglichkeit, so daß kein oder nur ein geringes Signal in den Sensor eingeleitet wird. Diese Dämpfung kann auch zusätzlich oder nur durch Abgabe von Schwingungsenergie in das den Eingangsbefehl einleitende Medium, zum Beispiel die Hand einer Person oder das Ansteigen einer Flüssigkeit, womit sich das das Stellteil umgebende Medium von gasförmig zu flüssig ändert, bewirkt werden; der gleiche Effekt stellt sich ein, wenn die Beweglichkeit unbeabsichtigt durch innere oder äussere Einflüsse, wie Korrosion in den Lagerstellen, Bruch der das mechanisch bewegliche Stellteil tragenden Teile, wie Federn usw. herabgesetzt wird.

Die so verursachte Verringerung der Amplitude des Sensorsignals zeigt die Beaufschlagung des Stellteils durch ein eingeleitetes Eingangssignal oder eine andere, im Gerät oder seiner Versorgung auftretende Störung an, wodurch ein Ausgangssignal ausgelöst wird.

Dem Befehlsgerät kann ein Schwellwert-Schalter (Amplituden-Diskriminator) nachgeschaltet werden, der das Abfallen der vom Sensor abgegebenen Amplitude unter einen vorgegebenen Wert diskriminiert und in ein verwertbares Ausgangssignal umwandelt.

Weitere Merkmale der Erfindung sind in den Unteransprüchen und der Beschreibung der Figuren dargestellt, wobei bemerkt wird, daß alle Einzelmerkmale und alle Kombinationen von Einzelmerkmalen erfindungswesentlich sind.

In den Figuren ist die Erfindung an zwei Ausführungsformen beispielsweise dargestellt, ohne auf diese beschränkt zu sein.
Es zeigt:
- Figur 1: eine schematische Darstellung der Ausbildung und Anordnung der wesentlichen Merkmale einer ersten Ausführungsform des erfindungsgemäßen Befehlsgerätes mit überwachtem Stellteil und
- Figur 2: eine entsprechende Darstellung für eine zweite Ausführungsform.

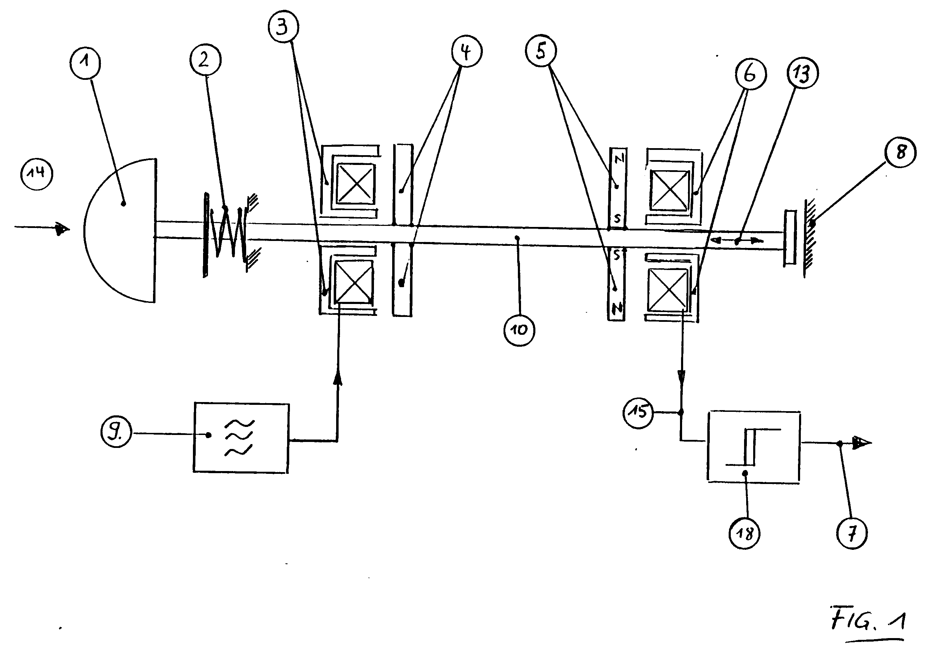

Figur 1 zeigt ein Stellteil, das aus einem Drucktaster 1 und einem fest mit diesem verbundenen inneren Stößel 10 besteht. Der innere Stößel 10 ist über nicht näher verdeutlichte Lagerelemente so gelagert, daß er ausschließlich eine Hin- und Herbewegung in Richtung seiner Längsachse vollführen kann. Mit dem Stößel 10 ist ein Anker 4 verbunden, der mit einem Elektromagneten 3 zusammenwirkt, Elektromagnet 3 und Anker 4 stellen den Antrieb des Stellteiles dar. Mit dem Stößel 10 ist ferner ein Dauermagnet 5 fest verbunden, der mit einem stationären Elektromagneten 6 zusammenwirkt, der Dauermagnet 5 und der Elektromagnet 6 stellen zusammen einen Sensor dar.

Durch den mittels eines eigenen Oszillators 9 gespeisten Antrieb wird das Stellteil so lange in eine dauernde oszillierende Bewegung 13 bestimmter Amplitude versetzt, wie kein Eingangsbefehls 14 eingeleitet wird und eine ausreichende Beweglichkeit vorhanden ist. Der Eingangsbefehl 14 hat dabei die gleiche Richtung wie die oszillierende Bewegung 13 des Stellteiles. Diese oszillierende Bewegung wird von dem Sensor erkannt und als Sensorsignal 15 abgegeben, das nach Diskriminierung in einem Amplituden-Diskriminator 18 als binäres Ausgangssignal 7 an ein nachgeschaltetes Steuersystem einer Maschine oder Anlage abgegeben wird.

Wird in das Stellteil, das heißt in den Drucktaster 1 ein Eingangsbefehl 14 eingeleitet, erfährt es selbst und auch der innere Stößel 10 durch Anlegen an einen festen Anschlag 8 eine Einschränkung der Beweglichkeit, so daß kein oder nur ein geringes Signal in den Sensor eingeleitet wird.
Der gleiche Effekt stellt sich ein, wenn die Beweglichkeit unbeabsichtigt durch innere oder äußere Einflüsse, wie Korrosion in den Lagerstellen, Bruch des Stößels 10 oder einer zwischen einem stationären Anschlag und einer mit dem Stössel 10 verbundenen Platte angeordneten Feder 2 herabgesetzt wird. Die so verursachte Verringerung der Amplitude des Sensorsignals 15 zeigt die Beaufschlagung des Drucktasters 1 durch einen eingeleiteten Eingangsbefehl 14 oder eine andere, im Gerät oder seiner Versorgung auftretende Störung an, wodurch das Ausgangssignal 7 ausgelöst wird.

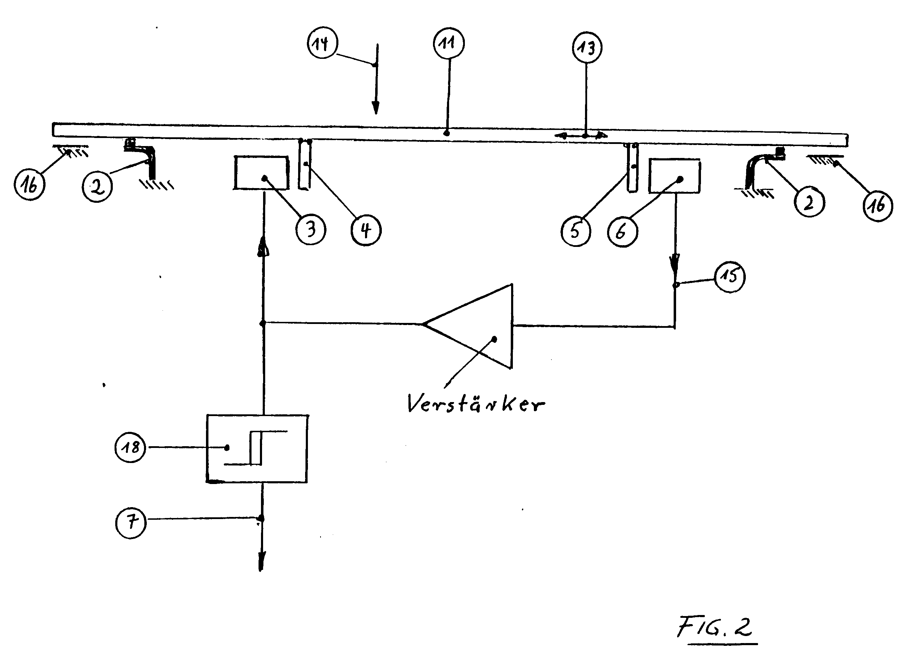

In Figur 2 dargestellte Teile des Befehlsgerätes, die mit solchen in der Figur 1 hinsichtlich ihrer Funktion übereinstimmen, sind der Einfachheit halber mit gleichen Bezugsziffern bezeichnet. Das in Figur 2 gezeigte Befehlsgerät zeigt ein Stellteil, das als Schaltplatte 11 ausgebildet ist. Im angetriebenen Zustand der Schaltplatte 11 erfolgt dort die oszillierende Bewegung 13 senkrecht zur Richtung eines Eingangsbefehles 14. Ferner erfolgt der Antrieb selbsterregt, indem das Sensorsignal 15 über einen Verstärker nicht nur dem Amplituden-Diskriminator 18 sondern auch dem Elektromagneten 3 zugeführt wird. Wird in die Schaltplatte 11 ein Eingangsbefehl 14 eingeleitet, erfährt diese durch Anlegen an Reibflächen 16 gleichfalls eine Einschränkung der Beweglichkeit, so daß entsprechend dem zuvor beschriebenen kein oder nur ein geringeres Signal in den Sensor eingeleitet wird.

## Patentansprüche

1. Befehlsgerät mit einem beweglichen Stellteil zur Ein- und Fortleitung eines Eingangsbefehles an Steuersysteme, insbesondere von Maschinen, Anlagen oder dgl., **dadurch** **gekennzeichnet,** daß das Stellteil (1, 10; 11) durch einen Antrieb (3, 4) in eine oszillierende Bewegung (13) versetzbar ist, diese durch das Stellteil (1, 10; 11) zu einem Sensor (5, 6) fortleitbar und von diesem erkennbar ist, wobei die Einleitung eines Eingangsbefehles (14) die oszillierende Bewegung (13) dämpft.

2. Befehlsgerät nach Anspruch 1, **dadurch gekennzeichnet,** daß die Dämpfung nach einer Amplituden-Diskriminierung (18) als binäres Ausgangssignal (7) abgebbar ist.

3. Befehlsgerät nach Anspruch 1 oder 2, **dadurch gekennzeichnet,** daß der Antrieb als magnetisches System (3, 4) ausgebildet ist, die insbesondere aus einem Elektromagneten (3) und einem, mit dem Stellteil (10; 11) verbundenen Anker (4) besteht.

4. Befehlsgerät nach einem der Ansprüche 1 bis 3, **dadurch** **gekennzeichnet,** daß der Sensor (5, 6) als elektromechanisches System (5, 6) ausgebildet ist, das insbesondere aus einem Elektromagneten (6) und einem mit dem Stellglied (10; 11) verbundenen Dauermagneten (5) besteht.

5. Befehlsgerät nach Anspruch 1 oder 2, **dadurch gekennzeichnet**, daß der Antrieb und/oder der Sensor als pneumatischhydraulisch, kapazitiv oder piezoelektrisch wirkendes System ausgebildet ist.

6. Befehlsgerät nach einem der Ansprüche 1 bis 5, **dadurch** **gekennzeichnet**, daß die Speisung des Antriebes (3, 4) fremderregt durch einen eigenen Oszillator (9) oder selbsterregt durch Rückführung des Sensorsignals (15) in den Antrieb (3, 4) erfolgt.

7. Befehlsgerät nach einem der Ansprüche 1 bis 6, **dadurch** **gekennzeichnet,** daß das Stellteil einteilig als Schaltleiste oder Schaltplatte (11) ausgebildet ist.

8. Befehlsgerät nach Anspruch 7, **dadurch gekennzeichnet,** daß mit dem Stellteil (11) antriebsseitig der Anker (4) oder der Elektromagnet (3) und sensorseitig der Dauermagnet (5) oder der Elektromagnet (6) verbunden ist.

9. Befehlsgerät nach einem der Ansprüche 1 bis 8, **dadurch** **gekennzeichnet,** daß das Stellteil (1, 10) mehrteilig, insbesondere zweiteilig ausgebildet ist.

10. Befehlsgerät nach Anspruch 9, **dadurch gekennzeichnet,** daß das Stellteil (1, 10) einen Drucktaster (1) und eine mit diesem verbundene Tasterstange (10) aufweist, wobei mit der Tasterstange (10) antriebsseitig der Anker (4) oder der Elektromagnet (3) und sensorseitig der Dauermagnet (5) oder der Elektromagnet (6) verbunden ist.

## Claims

1. A control switch with a movable operating element for introducing and transmitting an input instruction to control systems, particularly of machines, installations or the like, characterised in that the operating element (1, 10; 11) can be set in an oscillating motion (13) by a drive (3, 4), which oscillating motion can be transmitted by the operating element (1, 10; 11) to a sensor (5, 6) and can be recognised by the latter, wherein the introduction of an input instruction (14) damps the oscillating motion (13).

2. A control switch according to claim 1, characterised in that the damping can be output as a binary output signal (7) in accordance with an amplitude discrimination (18) operation.

3. A control switch according to claim 1 or 2, characterised in that the drive is constructed as a magnetic system (3, 4) which consists in particular of an electromagnet (3) and an armature (4) attached to the operating element (10; 11).

4. A control switch according to any one of claims 1 to 3, characterised in that the sensor (5, 6) is constructed as an electromechanical system (5, 6), which consists in particular of an electromagnet (6) and a permanent magnet (5) attached to the operating element (10; 11).

5. A control switch according to claim 1 or 2, characterised in that the drive and/or the sensor is constructed as a pneumatically-hydraulically, capacitively or piezo-electrically acting system.

6. A control switch according to any one of claims 1 to 5, characterised in that the supply to the drive (3, 4) is provided externally by a separate oscillator (9) or is self-induced by feeding back the sensor signal (15) into the drive (3, 4).

7. A control switch according to any one of claims 1 to 6, characterised in that the operating element is constructed in one piece as a contact strip or switch plate (11).

8. A control switch according to claim 7, characterised in that the armature (4) or the electromagnet (3) is attached to the operating element (11) on the drive side and the permanent magnet (5) or the electromagnet (6) is attached to the operating element on the sensor side.

9. A control switch according to any one of claims 1 to 8, characterised in that the operating element (1, 10) is of multi-part construction, particularly of two-part construction.

10. A control switch according to claim 9, characterised in that the operating element (1, 10) comprises a push-button (1) and a transmitter rod (10) attached thereto, wherein the armature (4) or the electromagnet (3) is attached to the transmitter rod (10) on the drive side and the permanent magnet (5) or the electromagnet (6) is attached to the transmitter rod on the sensor side.

## Revendications

1. Dispositif de transmission d'ordre utilisant un organe de commande mobile pour engendrer et transmettre un ordre d'entrée à un système de commande notamment de machines, installations ou objets analogues, caractérisé en ce qu'un entraîneur (3, 4) peut mettre en mouvement oscillatoire (13) l'organe de commande (1, 10 ; 11) qui peut transmettre ce mouvement à un détecteur (5, 6) capable de l'identifier, la réception d'un ordre d'entrée ayant pour effet d'amortir le mouvement oscillant (13).

2. Dispositif de transmission d'ordre selon la revendication 1, caractérisé en ce que l'amortissement peut être transformé par un détecteur d'amplitudes (18) en un signal de sortie binaire (7).

3. Dispositif de transmission selon la revendication 1 ou 2, caractérisé en ce que l'entraîneur est un système magnétique (3, 4) constitué en particulier d'un électroaimant (3) et d'une armature (4) reliée à l'organe de commande (10 ; 11).

4. Dispositif de transmission d'ordre selon une des revendications 1 à 3, caractérisé en ce que le détecteur (5, 6) est un système électromécanique (5, 6) constitué en particulier d'un électroaimant (6) et d'un aimant permanent (5) relié à l'organe de commande (10 ; 11).

5. Dispositif de transmission d'ordre selon la revendication 1 ou 2, caractérisé en ce que l'entraîneur et/ou le détecteur est un système hydro-pneumatique, capacitif ou piézo-électrique.

6. Dispositif de transmission d'ordre selon une des revendications 1 à 5, caractérisé en ce que l'entraîneur (3, 4) est alimenté indépendamment par un oscillateur spécifique (9) ou autoalimenté par retour du signal de detection (15) à l'entraîneur (3, 4).

7. Dispositif de transmission d'ordre selon une des revendications 1 à 6, caractérisé en ce que l'organe de commande est constitué d'une barre ou plaque commutatrice (11) monobloc.

8. Dispositif de transmission de commande selon la revendication 7, caractérisé en ce que l'organe de commande (11) est relié, côté entraînement à l'armature (4) ou à l'électroaimant (3), côté détecteur à l'aimant permanent (5) ou à l'électroaimant (6).

9. Dispositif de transmission selon une des revendications 1 à 8, caractérisé en ce que l'organe de commande (1, 10) est en plusieurs parties, deux en particulier.

10. Dispositif selon la revendication 9, caractérisé en ce que l'organe de commande (1, 10) comporte un détecteur de pression (1) auquel est relié une tige de détection (10) elle-même reliée, côté entraîneur à l'armature (4) ou à l'électroaimant (3) et côté détecteur à l'aimant permanent (5) ou l'électroaimant (6).
